Europäisches Patentamt

European Patent Office

Office européen des brevets

(11) Publication number: **0 384 595**
**A2**

## (12) EUROPEAN PATENT APPLICATION

(21) Application number: **90301097.3**

(22) Date of filing: **02.02.90**

(51) Int. Cl.5: **H03K 5/13, H03K 5/15**

(30) Priority: **22.02.89 GB 8903965**

(43) Date of publication of application:
**29.08.90 Bulletin 90/35**

(84) Designated Contracting States:
**DE ES FR IT NL**

(71) Applicant: **STC PLC**
**1B Portland Place**
**London W1N 3AA(GB)**

(72) Inventor: **Naden, James Mark**
**3 Turpins Close**
**Mimram View, Hertford SG14 2EH(GB)**

(74) Representative: **Dennis, Mark Charles et al**
**STC Patents West Road**
**Harlow Essex CM20 2SH(GB)**

(54) **Digital phase shifter.**

(57) A digital phase shift arrangement comprising a frequency multiplier (10) to which an input signal can be applied, frequency division means to which the output of the multiplier is applied, the frequency division means (11,12) being arranged to produce a plurality of outputs of identical frequency each delayed by a different amount with respect to the input frequency and means (13,14) for selecting one of the outputs of the frequency division means.

*Fig. 1.*

EP 0 384 595 A2

$FREQ = mf \div m/2, \emptyset$

## Digital Phase Shifter

This invention relates to a digital phase shifter arrangement having a selectable incremental phase shift

Many phase shifter designs rely on the use of capacitor resistor networks (e.g. P. Horowitz, W. Hill, "The Art of Electronics", p.63 Cambridge University Press, 1980) to achieve the phase shift. This phase shift is then frequency dependent because of the frequency dependent impedance of the capacitors.

It is an object of the present invention to provide a digital phase shift arrangement wherein the phase shift selected is independent of the operating frequency.

According to the invention there is provided a digital phase shift arrangement comprising a frequency multiplier to which an input signal can be applied, frequency division means to which the output of the multiplier is applied, the frequency division means being arranged to produce a plurality of outputs of identical frequency each delayed by a different amount with respect to the input frequency and means for selecting one of the outputs of the frequency division means.

The invention will now be described with reference to the accompanying drawings, in which:-

Fig. 1 is a block diagram of a digital phase shifter, and

Fig. 2 is a timing diagram.

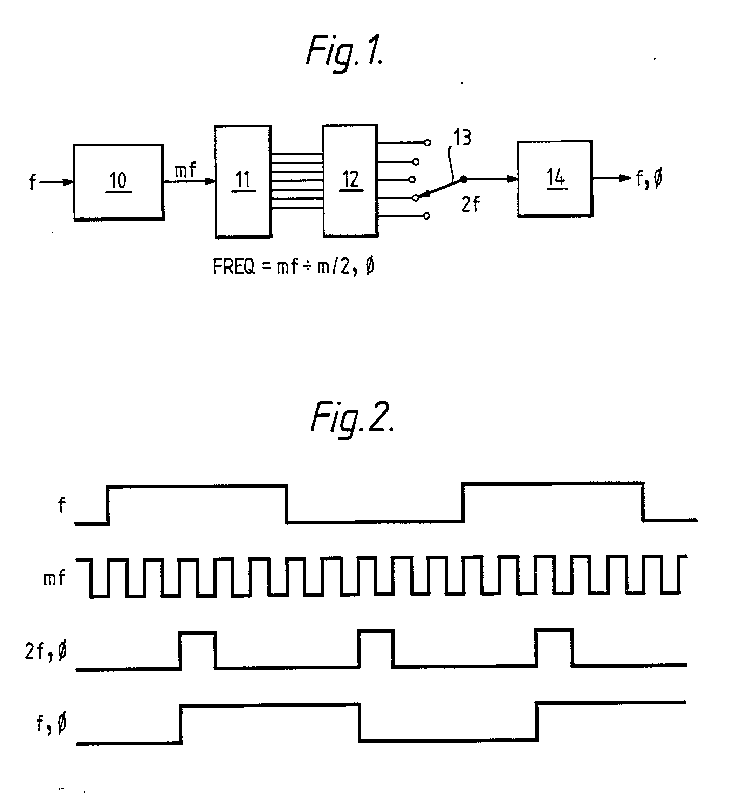

In the arrangement shown in Fig. 1 an input signal, which is typically a 0-5v square wave of frequency f, is applied to a frequency multiplier 10, the output of which is a similar signal of frequency mf where m is the multiplier constant. If a phase locked loop frequency multiplier is used, such as that described in the above quoted reference work at p.342, then the output frequency mf has a fixed phase relationship with the input frequency f. This output frequency mf is then applied as a clock input to a multistage counter 11. The outputs of the counter stages are fed in parallel as a binary digital word to a digital decoder 12. The net effect of the counter/decoder combination is to produce a pulse of duration equal to one clock cycle for each m/2 clock pulses into the counter, the output pulse coinciding with the $n^{th}$ clock pulse where n is selectable between 1 and m/2. The outputs from the decoder 12 are fed to a selector switch 13 and the selected output is applied to a binary counter 14. The binary counter divides the selected decoder output, which is a signal of frequency 2f, by 2 to recover the original frequency f and also restores the duty cycle to 50%. Thus the output from the binary counter is at the same frequency as the original input signal f but is delayed by (n-1) cycles of the mf signal. By selecting different outputs from the decoder, using the switch 13, this phase delay may be varied. An example of the timing diagram for a given phase shift $\theta$ is shown in Fig. 2.

The invention is readily implemented using current commercially available CMOS integrated circuits. The combination of frequency multiplier and delayed division of the multiplier output produces a phase shift which is independent of the input frequency.

The invention finds application in, inter alia, well logging equipments utilising fibre optic sensors having resonant sensing elements. Such resonant elements are driven by an alternating frequency signal which is in phase with the resonant element. The digital phase shifter is employed to adjust the phase of the drive signal to match the phase of the resonant element. The fibre optic sensors are used to monitor temperature and pressure in the well.

## Claims

1. A digital phase shift arrangement characterised in that there is a frequency multiplier to which an input signal can be applied, frequency division means to which the output of the multiplier is applied, the frequency division means being arranged to produce a plurality of outputs of identical frequency each delayed by a different amount with respect to the input frequency and means for selecting one of the outputs of the frequency division means.

2. A digital phase shift arrangement according to claim 1 characterised in that said frequency division means comprises a multistage counter to which the output of the multiplier is applied as a clock signal and a digital decoder to which the outputs of the counter stages are fed in parallel as a binary digital word.

3. A digital phase shift arrangement according to claim 2 characterised in that said selecting means comprises switch means arranged to select one of the outputs of the decoder.

4. A digital phase shifter arrangement according to claim 3 including frequency division means to which the output of the selection switch means is applied to produce an output signal having the same frequency as the input signal when the frequency of the selected decoder output is a multiple of the input signal frequency.

5. A well logging equipment including a digital phase shift arrangement as claimed in claim 4.

6. A fibre optic sensor device including a digital phase shift arrangement according to claim 4 and further including a resonant element wherein the phase shift arrangement is adapted to adjust the phase of an alternating frequency signal driving the resonant element.

# Fig.1.

FREQ = mf ÷ m/2, ∅

# Fig.2.